# EUROPEAN PATENT SPECIFICATION

(11) **EP 2 025 010 B1**
(45) Date of publication and mention of the grant of the patent: **02.11.2011**
(21) Application number: 07722641.3
(22) Date of filing: 01.06.2007
(51) Int. Cl.: H01L 39/14, H01L 39/24, C04B 35/74

(54) **HIGH CRITICAL TEMPERATURE SUPERCONDUCTING ARTICLE WITH IMPROVED MECHANICAL STRENGTH**
SUPRALEITENDER ARTIKEL MIT HOHER KRITISCHER TEMPERATUR MIT VERBESSERTER MECHANISCHER FESTIGKEIT
ARTICLE SUPRACONDUCTEUR À HAUTE TEMPÉRATURE CRITIQUE DE RÉSISTANCE MÉCANIQUE AMÉLIORÉE

(30) Priority: 02.06.2006 DK 200600758
(43) Date of publication of application: 18.02.2009
(73) Proprietor: Danmarks Tekniske Universitet, 2800 Kgs. Lyngby (DK)
(72) Inventor: GRIVEL, Jean Claude, DK-4330 Hvalsø (DK)
(74) Representative: Schwarze, Holm
(86) International application number: PCT/DK2007/000264
(87) International publication number: WO 2007/140775

(56) References cited:
- EP-B1- 0 346 499
- EP-B1- 0 358 779
- WO-A2-02/37581
- JP-A- 4 188 511

## Description

### Field of invention

The invention relates generally to a superconducting article comprising a superconducting material, a first matrix layer surrounding said superconducting material, at least a reinforcement layer made of a second material surrounding said first layer, and a third layer made of a third material surrounding said reinforcement layer.

### Background of the invention

High critical temperature superconducting tapes for power applications are today primarily fabricated using the "powder-in-tube" (PIT) manufacturing process. The process comprises packing superconducting powders inside a silver (Ag) tube and by mechanical means to deform the composition into a desired geometry e.g. a tape. The choice of silver is made because the tube surrounding the superconducting powder core is required to be permeable to oxygen at least at high temperatures and the material of the tube may not react with the superconducting powder. Ag fulfils both of these requirements. One step in the abovementioned fabrication process is at least one heat treatment of the tape at high temperature in order to sinter the superconducting powder core of the tape.

A problem of the above fabrication process is that the silver tube becomes (more) fragile during the mechanical deformation and/or the one or more heat treatments thereby increasing the risk of mechanical failure during handling and operation of the superconducting tape. A further problem is that the amount of silver used is large in order to compensate for the reduced mechanical strength of the tape.

EP 0 449 161 describes a method of preparing a bismuth oxide superconductor in a single metal sheath. The composition of the superconducting oxide and the preparation of the same are described in detail together with dimensions of said metal sheath.

DD 296 179 describes a system and a method for the fabrication of a superconducting wire. Said superconducting wire comprises a superconducting oxide and a silver-tube. Said silver tube is mechanically processed either before or after the introduction of the superconducting oxide into the tube. Further, the silver tube is heat-treated either before or after the introduction of the superconducting oxide into the tube. Said heat treatment is partly used for an alloying of said silver tube in order to increase the strength of said silver tube. Said alloying of said silver tube may be performed using an electrochemical process.

Even though the last-mentioned prior art superconducting wire solves the problem of increasing the strength of said tube comprising said superconducting oxide, this increase is limited, because the strength of the Ag-based alloy formed by means of the above prior art fabrication method still has a comparatively low value. Therefore, it remains a problem to significantly increase the strength of the protective layer enclosing said superconducting oxide in an easy and cheap way, while ensuring sufficient oxygen to reach the core material during the production process, in particular during the heat processing.

EP 0 358 779, EP 0 346 499 and JP 04 188511 describe methods for the fabrication of a mechanically reinforced superconducting wire. Said superconducting wire comprises a superconducting oxide and a silver matrix in contact with the superconducting oxide. Said silver matrix is further partially surrounded by an external layer made of another metal. Holes are present in said external layer to allow oxygen diffusion between the superconducting oxide and the surrounding atmosphere during processing.

This last-mentioned prior art superconducting wire only partly solves the problem of increasing the strength of said superconducting wire, because said outer layer is prone to uncontrollable deformation during high-temperature processing. Therefore it remains a problem to produce long superconducting wires with suitable homogeneity.

WO 02/37581 describes methods for the fabrication of a wire in the form of a multifilament core, where all individual filaments are further surrounded by a layer of a high-resistivity material.

Such a geometry is likely to result in extended, contact areas between the filament cores and the high resistivity material, thus resulting in severe degradation of the superconducting properties.
Therefore it remains a problem to produce wires with reliable architecture.

### Summary

It is desirable to increase the mechanical strength of a superconducting article comprising a superconducting material including oxygen as one of its constituents, e.g. a superconducting oxide, an oxycarbonate, an oxyfluoride, an oxychloride, etc. or a combination thereof. It is further desirable to obtain said strengthening in a simple, cheap and reliable way. It is further desirable to ensure oxygen to reach said superconducting oxide, in particular during a heating process.

According to one embodiment a superconducting article is provided, the article comprising:
- at least one core including a core material, the core material including a superconductive material or one or more materials that are convertible into a superconductive material;
- a first matrix of a first material surrounding each core;
- a reinforcement matrix of a second material partially surrounding the first material; wherein said reinforcement matrix comprises at least one opening in a circumference of said reinforcement matrix, said opening allowing oxygen to reach the first matrix during a manufacturing process of the superconducting article;
- a third matrix of a third material surrounding the second material.

Hence, the superconducting material is encased in a composite matrix, e.g. a metal matrix, including the first matrix, the reinforcement matrix, and the third matrix materials, e.g. in the form of respective layers such as tubular layers. In particular, when the reinforcement layer covers only a part of the circumferential surface of the first layer, it leaves one or more openings in the circumference of the reinforcement layer for allowing oxygen to penetrate to the first material, in particular during a heating/sintering process during the manufacturing of the superconducting article. Even in a situation where the material is a superconducting material such as a superconducting oxide, the heating process allows a sintering of the ceramic grains of the superconducting material so as to allow the transfer of the superconducting current from grain to grain along the article. Furthermore, the diffusion of oxygen through the opening and the third layer ensures that the superconducting oxide includes oxygen in a sufficient stoichiometric relationship to ensure efficient superconductive properties of the resulting article.

The third layer prevents said at least one reinforcement matrix from deforming in an uncontrollable way during processing.

In one embodiment, the third layer is the outermost or external layer of the superconducting article. In some embodiments, the third layer surrounds the reinforcement layer completely.

Since the second material is separated from the core material by the first material, the second material is not required to be inert with respect to the core material, but a material may be chosen that is chemically reactive with the core material. This and the fact that the second material as such is not required to be oxygen permeable allows a wider range of materials to be used as a second protective sheath, in particular materials with a high mechanical strength. Furthermore, this flexibility in the choice of the second material allows the choice of a relatively less expensive material. In one embodiment, the first and second materials are selected not to be reactive with another, or at least to only react with each other to a limited extent, at least under the conditions used for the manufacture of the superconducting article. Examples of suitable materials for the reinforcement layer include one or more metals, e.g. non-precious metals, e.g. metals selected from the group of metals consisting of Ni, Cr, Cu, Fe, Ti, V, Mn, Co, Zn, Zr, Nb, Mo, Hf, Ta, W, Al, or combinations/alloys thereof.

When the reinforcement matrix has a radial thickness larger than a radial thickness of the first matrix and/or the third matrix, a particular high mechanical strength and/or low production cost may be achieved.

In some embodiments, said reinforcement matrix is added to the superconducting article prior to one or more mechanical deformations and/or prior to one or more heat treatments. In some embodiments, the reinforcement matrix and/or the third matrix include materials that do not suffer extensively from corrosion during one or more heat treatments in an atmosphere comprising oxygen.

In some embodiments, the third material is selected to be inert with respect to the second material, or at least to only react with the second material to a limited extent, at least under the conditions used for the manufacture of the superconducting article.

The core material may have the form of an elongated core. The first matrix and/or the reinforcement matrix and/or the third matrix may be provided as respective tubular layers, i.e. as any suitable hollow, elongated member, such as a tube for providing a protective sheath around the core material. The elongated member/tube may have any suitable cross-sectional shape, such as circular, elliptical, square, rectangular, or the like. In one embodiment, the tubular layer is a cylindrical tube; in another embodiment the tubular layer has the form of a flat tape, e.g. of substantially rectangular cross-section. The tubular layer may include one or more elongated cavities/tubular spaces that is/are filled with the core material.

In some embodiments, the article has a largest dimension along at least one direction and smaller dimensions in directions across the direction(s) of largest dimension. The term circumferential surface of an article as used herein is intended to refer to the surface along, typically parallel to, a longitudinal axis of the article, i.e. an axis along one of the directions of largest dimension. Generally, in addition to the circumferential surface, an article may further have two end faces through which the longitudinal axis projects.

Generally, an elongated article has a direction of largest dimension defining the longitudinal axis of the elongated article and shorter dimensions along directions across, in particular perpendicular, to the longitudinal axis. A square plate, for example, has two directions with largest dimensions. For example, the circumferential surface of en elongated article such as a wire, an elongated plate, or a tape is also referred to as a generalized cylinder. Hence, the term circumferential surface of an elongated article as used herein is intended to refer to the surface along, typically parallel to, a centre longitudinal axis of the elongated article. Generally, in addition to the circumferential surface, an elongated article typically further has two end faces through which the longitudinal centre axis projects.

When said first and third material are permeable to oxygen at least under certain conditions, e.g. a certain temperature range, oxygen can reach the core material of the superconducting article in sufficient quantities. Consequently, it is preferred that the first and third materials are permeable to oxygen at least under the process conditions under which the core material is sintered. Typical temperature ranges are 20°C-1300°C, 300°C - 960°C such as 400°C-700°C or 700°C-900°C. Furthermore, since the first material is in contact with the core material, it is preferred that the first material is inert in respect of the core material, in particular a material that does not react with the core material during the heat treatment. Examples of suitable materials include a metal or metal alloy, e.g. including one or more precious metals, such as silver (Ag).

In a preferred embodiment, the openings are formed as one or more channels extending through the entire thickness of the reinforcement layer, thereby providing a particularly effective oxygen transfer. In general, the openings are provided in addition to any opening at the cross sectional end faces of the article. In embodiments of the invention, the openings extend through the reinforcement layer in a direction across, e.g. perpendicular to, a longitudinal centre axis of the article, e.g. radially towards the longitudinal centre axis. The openings provide a radial passage to oxygen transfer. In one embodiment, the at least one opening is formed as an elongated channel along a longitudinal axis of the reinforcement tubular layer/sheath. In one embodiment, the at least one opening extends radially through a circumferential wall of the tubular layer.

When said opening is filled with a material that is permeable to oxygen, an accidental closure of the opening during a deformation process is avoided.

The reinforcement layer is surrounded by the third layer. The third layer material may be the same material as the first material of the first layer or a different material. For example, the third material may be a metal or metal alloy, such as Ag, Ag-based alloys, oxidation hardened Ag-based alloys, and/or the like.

The present invention relates to different aspects including the superconducting article described above and in the following, and a method of manufacturing such an article, each yielding one or more of the benefits and advantages described in connection with the above-mentioned superconducting article, and each having one or more embodiments corresponding to the embodiments described in connection with the above-mentioned superconducting article and/or disclosed in the claims.

In particular, in another aspect the invention is related to a method of manufacturing a superconducting article. Embodiments of the method comprise:
- providing at least one core including a core material, the core material comprising a superconductive material or one or more materials convertible into a superconductive material;
- surrounding the at least one core by at least one first matrix comprising a first material;
- partially surrounding the at least one first matrix by at least one reinforcement matrix of a second material;
- surrounding the at least one reinforcement matrix, by a third matrix of a third material;
- processing the core material surrounded by the first matrix, the reinforcement matrix, and the third matrix so as to obtain a sintered superconducting material; wherein said reinforcement matrix comprises at least one opening in a circumference of said reinforcement matrix, said opening allowing oxygen to reach the first matrix during a processing step.

The at least one opening may be provided in any suitable way, e.g. by a grinding, a polishing process, a cutting process, or another treatment with an abrasive material, an etching process, or the like. The openings may be provided before, during or after the deformation process. For example, the reinforcement layer may be provided as a tube, into which a longitudinal slit is cut before the first tubular layer is inserted. Similarly, the third layer may be provided as a tube into which the reinforcement layer, optionally the reinforcement layer surrounding the first tubular layer, is inserted.

The deformation and heating steps may be performed in any suitable way known in the art, e.g. as described in EP 0 449 161 and/or DD 296 179. In particular, the deformation process may include pressing, rolling, drawing stretching, etc. or any combination thereof. The reinforcement layer including the one or more openings is provided around the first layer prior to at least one heat treatment of the material, e.g. a heat treatment at a temperature higher than 500°C.

It is a further advantage that the manufacturing process described herein can be performed in a short time, because a single heat treatment is sufficient in many cases instead of the conventionally required multiple treatments with intermediate densification operations. In particular, the high-temperature superconducting oxides typically form crystallites that have a plate-shaped geometry. During tape manufacture, the deformation process typically results in a strong grinding of the crystallites, which acquire a more rounded-shape geometry and a significantly smaller size. During the subsequent high-temperature treatment, the crystallites grow again and form elongated plates by an essentially 2-dimensional growth process. A similar phenomenon occurs when starting from materials that may be converted into a superconductive oxide. This peculiar growth process makes the crystallites "push" each other during the heat-treatment. Ag being extremely malleable at high temperature, it can not always hold the material so that the overall thickness of the tape increases and an extended porosity develops in the ceramic core, which in turn results in a bad sintering of the crystallites. Therefore, the need for additional densification steps and subsequent sintering arises in many prior art manufacturing processes. The harder, reinforcement sheath of the superconducting article described herein is believed to prevent the formation of porosity by exerting a pressure on the ceramic core during the growth of the crystallites.

### Brief description of the drawings

Figs. 1-3 schematically show examples of a superconducting wire or tape.
Fig. 4 shows a flowchart of a process for preparing a superconducting article.
Fig. 5 schematically shows further examples of a superconducting wire or tape.

### Detailed description of the invention

In the following detailed description of exemplary embodiments of the invention, reference is made to the accompanying drawings which form a part hereof, and by way of illustration specific exemplary embodiments are shown in which the present invention may be practiced. The following detailed description is, therefore, not to be taken in a limiting sense. In the drawings, like reference signs refer to like or corresponding elements, components, features, etc.

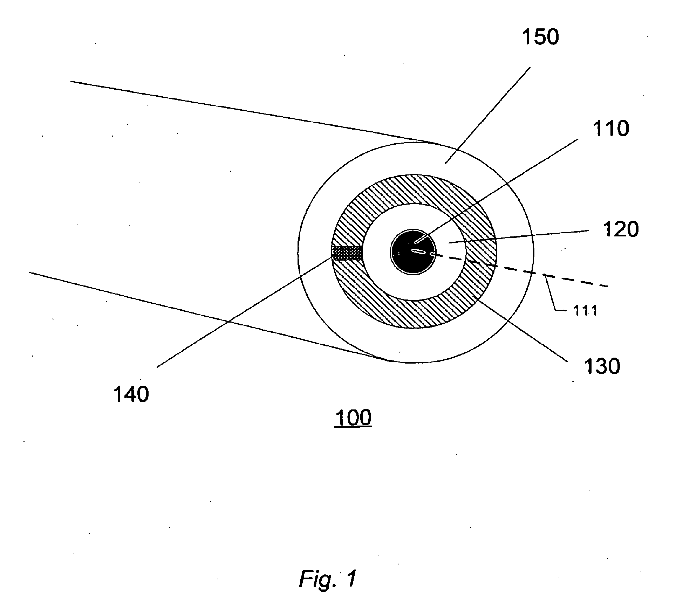

Fig. 1 shows a schematic drawing of a superconducting wire as an example of a superconducting article. The superconducting wire 100 comprises a core/filament of superconducting material 110, a first tubular layer 120 of a first material surrounding said superconducting material, and a reinforcement tubular layer 130 of a second material surrounding said first material. The reinforcement tubular layer includes an opening 140 in the form of a longitudinal channel. A third tubular layer 150 surrounds said second material. It is understood that in alternative embodiments, the reinforcement tubular layer may comprise more than one channel, e.g. two channels on opposite sides of the wire. Further, the at least one opening 140 may or may not be filled with the material of the first or third tubular layers or another material.

Said superconducting article may be a superconducting wire for high power transmission, e.g. a wire or tape having a length of 5 cm or more. Alternatively, said superconducting article may have any other tubular form, e.g. a tape or the like. The superconducting article has a longitudinal centre axis 111.

Generally, the superconducting material 110 may comprise a superconducting oxide such as Bi-(Pb)-Sr-Ca-Cu-O, Y-Ba-Cu-O, TI-Ba-Sr-Ca-Cu-O, Hg-Ba-Ca-Cu-O, or the like. Alternatively or additionally said superconducting material may comprise another type of superconducting material, or some or all starting components for a superconductive oxide to be created, e.g. by an oxidation process.

Generally, the material of the first tubular layer may comprise any metal or alloy that is preferably permeably to oxygen at least when heated to temperatures suitable for heat treatment of the core material. An example of a suitable material for the first tubular layer is silver (Ag) or a silver-alloy which is permeable to oxygen at high temperatures, e.g. higher than around 300°C. Preferably, the material of the first tubular layer is selected so it does not react with the superconductive material 110 of the core, or at least only reacts to a limited extent, i.e. in such a way that the superconducting properties of the superconducting material are not adversely affected to an extent making the superconducting article improper for use.

Generally, the material of said reinforcement tubular layer surrounding said first material 130 may be any material, in particular any material suitable for providing a reinforcement layer during and after the heat treatment of the article. For example, the second material may comprise any metal or alloy which reacts with said superconducting material, e.g. in a certain temperature range such as temperatures above 300°C. An example of a suitable material for the reinforcement tubular layer is nickel (Ni) or a nickel-alloy which reacts with the superconductive material at high temperatures (e.g. above 300°C), or any other suitable, relatively cheap metal or alloy, and/or a metal or alloy having a mechanical strength greater than the first material, e.g. greater than Ag, during and/or after one or more mechanical deformations and/or heat treatment(s). As can be seen from the figure, said reinforcement tubular layer is not in direct contact with said superconducting material. To this end, it is generally preferred that the first tubular layer 120 covers at least 99.9% of the circumferential surface of the core 110.

Said at least one opening in the circumference of said reinforcement layer 140 is large enough to allow oxygen to penetrate/diffuse from the surroundings of the superconducting article 100 and into said superconducting material 110 through said first tubular material 120, in particular during a heat treatment, e.g. a heat treatment in an oxygen- containing atmosphere. Said opening 140 can be made prior to, during or after a deformation process in which the superconducting article may be formed into a desired shape.

Said third tubular layer 150 consists of a material or combination of materials, which is permeable to oxygen at least when heated to temperatures suitable for heat treatment of the composite. Said third layer may include a component, which would react with the superconducting material if both were in contact. Generally, the third tubular layer may cover all or less than 100% of the circumferential surface of the reinforcement tubular layer 130.

An example of a suitable material for the third layer is silver (Ag) or a silver-alloy. Preferably the material of the third layer is selected so it does not react with the reinforcement tubular layer.

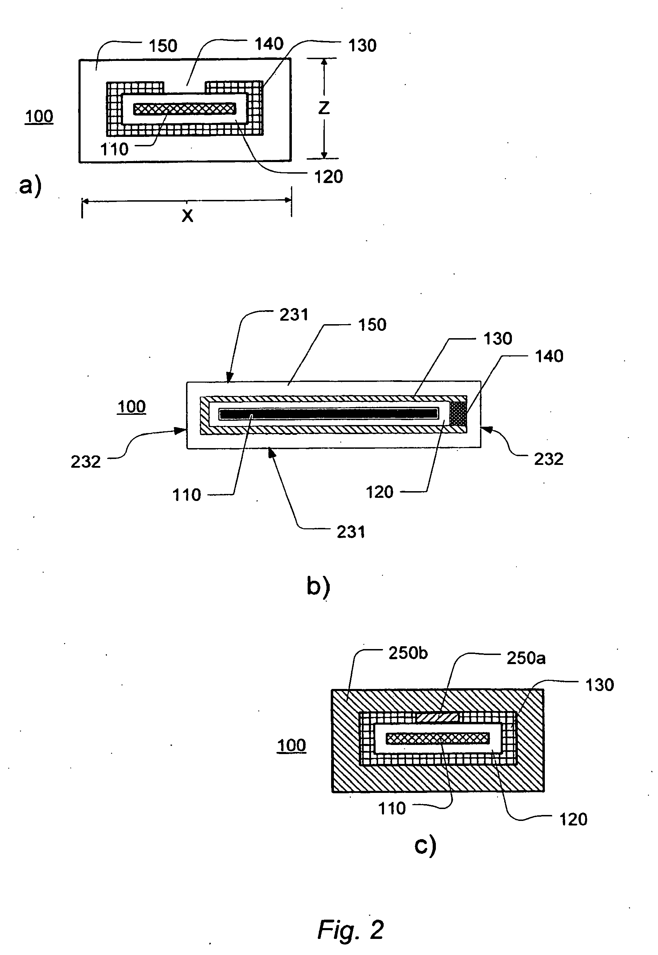

Fig. 2 shows schematic drawings of examples of a superconducting article in the form of a flat tape.

Fig. 2a shows a perspective view of a tape 100 having a layered structure similar to the article presented in figure 1. However, in the article of figure 2a the tubular structure is flattened out and is more tape-like. The flattening out of the tubular article may be performed in a deformation process, e.g. by pressing or rolling a generally cylindrical tubular wire, e.g. by initially providing a wire as shown in fig. 1 and subsequently rolling the wire to a thin tape. The tape of fig. 2a has a rectangular cross-section having a width X that is larger than the thickness Z of the tape. It will be appreciated, that alternative embodiments may have other elongated cross-sectional shapes with a width larger than a thickness of the tape. For example, such tapes may be produced by drawing wires with cross-sectional shapes other than circular.

The channel may be situated on any side of the tape. When the channel is situated on a thin edge of the tape, e.g. as illustrated in fig. 2b, the reinforcement layer 130 more effectively exerts a pressure on the core/filament during the heat process.

Fig. 2b shows a cross-sectional view of another example of a tape 100 having an elongated cross-sectional shape and a layered structure similar to the tape of Fig. 2a. Hence, the circumferential surface of the tape of fig. 2b includes generally two sides 231 corresponding to the width of the tape and two smaller sides 232, also referred to as edges, corresponding to the thickness of the tape. While the channel of the tape of fig. 2a is positioned in one of the large sides, the channel 140 in the article of Figure 2b, is positioned on one of the edges 232 of the tape.

The third layer 150 is preferably made of an oxygen-permeable material, preferably a metal or an alloy e.g. silver or a silver-alloy or an oxidation- hardened Ag-based alloy. Furthermore, the third layer supports the integrity of said superconducting article during processing.

Due to the presence of the reinforcement layer, the accumulated thickness of the first layer and the third layer may be kept small, thus providing a less expensive superconducting article.

The third layer 150 may be provided in any suitable way. For example, the third layer 150 may be provided prior to deformation as a profiled tube having an inner profile corresponding to the circumferential shape of the reinforcement layer. In one embodiment, the third layer may be provided as two part layers, e.g. as illustrated in fig. 2c.

Fig. 2c shows a cross-sectional view of another example of a tape 100 having a layered structure similar to the tape of fig. 2a. However, in the article of figure 2c, the third layer is provided as elongated stripe 250a and a tubular outer sheath 250b. The stripe 250a has dimensions corresponding to the dimensions of the channel 140 and is placed inside the channel. The composite with the reinforcement layer and the elongated stripe 250a is enclosed by the outer sheath 250b.

Generally a superconducting tape or wire may be produced in any suitable size. In one embodiment, the superconducting core of a superconducting tape may have a thickness z between 1µm - 1 cm, such as between 2µm - 500µm, such as between 5µm - 250µm, e.g. between 10µm - 100µm. Similarly, the core may have any width that is desirable for a given application. In some embodiments, a typical tape may have a width between 10µm - 50cm, such as between 10µm - 10cm, such as between 50µm - 5mm, such as between 100µm - 2mm.

Furthermore, the first layer, the reinforcement layer, and the third layer surrounding the core may be provided in a range of thicknesses. In some embodiments, the first layer may have a thickness between 1 µm - 200pm, such as between 2µm - 50µm, such as between 2µm - 5µm. In some embodiments, the reinforcement layer surrounding the first layer may have a thickness between 2µm - 500µm, such as between 5µm - 100µm, such as between 5µm - 50µm, for example between 10µm - 100µm, such as between 10µm - 50µm. The third layer may have a thickness equal to or different from the thicknesses of the first layer and the reinforcement layer.

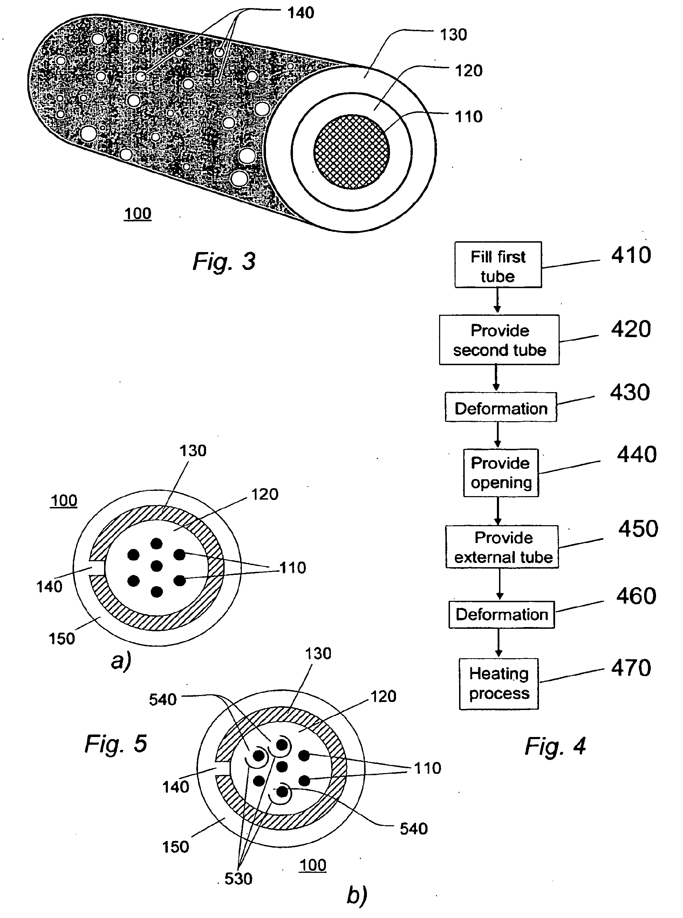

Fig. 3 shows a schematic drawing of yet another example of a part of a superconducting wire, where the third layer is not shown for the sake of clarity. The superconducting wire 100 of fig. 3 comprises a core of a superconducting material 110 and a first tubular layer 120 surrounding said superconducting material as described in connection with fig. 1. The wire 100 of fig. 3 further comprises a reinforcement tubular layer 130 surrounding said first material similar to the one described in connection with fig. 1. However, in the present example, the reinforcement tubular layer includes a plurality of openings in the form of holes 140 extending radially through the reinforcement layer.
As the described herein, in embodiments of the superconducting article, the reinforcement layer is further surrounded by the third layer, which is not shown in fig. 3 for the sake of clarity.

The holes may be preformed, or they may be made during a deformation process. For example, the reinforcement layer may be provided as a perforated tube, a tubular mesh, or the like.

As described in connection with fig. 2, the plurality of holes may be filled with an oxygen-permeable material, preferably a metal or an alloy e.g. silver or a silver-alloy, thereby avoiding closure of said plurality of holes during processing. The filling of the holes may take place during deformation of the article encased in the third layer, which is an oxygen permeable material as described above, thereby further protecting the integrity of the article.

It is understood that the holes may have same or different shapes and/or diameters, and that they may be distributed randomly across the reinforcement layer or in a predetermined order.

Fig. 4 shows a flowchart of a process for preparing a superconducting article.

In an initial step 410 a loose powder or compacted powder comprising a superconducting oxide material or one or more materials that may be converted into a superconducting oxide material is filled into a first tube or sheath made of a first metal or a metal-alloy which does not react extensively with the powder during one or more heat treatments at high temperature. The first tube or sheath thus forms a first tubular layer around the loose powder or compacted powder.

In subsequent step 420 the first substantially tube or sheath comprising the loose powder or compacted powder is introduced into a reinforcement tube or sheath made of a second metal or a metal-alloy which may be chemically reactive with the powder during one or more heat treatments at high temperature. Preferably, said second metal or metal-alloy is cheaper and/or mechanically harder than the non-reactive first metal, said first metal being in direct contact with the powder and thereby protects the powder against reactions with said second metal. Thus, the reinforcement tube or sheath provides a reinforcement tubular layer around the first tube or sheath.

In subsequent step 430 the composite comprising the powder, the first non-reactive metal and the second reactive metal is deformed if necessary to obtain a desired shape, e.g. rolled into a tape.

In subsequent step 440 an opening is created in the reinforcement tube, e.g. by grinding a side or edge of the deformed tube so as to locally remove the material of the reinforcement tube. The opening is preferably formed large enough to allow (efficient) transport of oxygen between the powder and the atmosphere surrounding said superconducting article during one or more heat treatments. It is understood that the opening may be performed prior to, during or after the end of the deformation process. Hence, generally, the reactive metal of the reinforcement tube only partially surrounds the first layer of the non-reactive metal that is in contact with the superconducting oxide.

In a subsequent step 450, the reinforcement tube is further surrounded by a further layer (i.e. third layer), e.g. a metal that is permeable to oxygen at temperatures higher than e.g. 300°C. In some embodiments, the third layer surrounds the reinforcement layer completely.

In subsequent step 460 the composite comprising the powder, the first non-reactive metal, the second reactive metal and the third metal is deformed if necessary to obtain a desired shape, e.g. rolled into a tape.

In subsequent step 470, the composite is heat treated in a known way to sinter the powder and/or convert it into a superconducting oxide material, e.g. as described in EP 0 449 161 and/or DD 296 179. Several subsequent heat treatments may be performed if necessary. For example, the heat treatment may be performed at temperatures sufficiently high to convert the core material into a superconducting oxide and/or to increase the superconducting properties of the core material e.g. at a temperature in the region between 20°C-1300°C, such as between 300°C - 960°C, such as between 400°C-700°C, such as between 700°C-900°C, e.g. at temperatures higher than e.g. 600°C. The precise heating schedule, including the number, duration, and temperature of the heat treatment(s) may depend on the type of the superconducting material used. During the processing, a thin corrosion layer may be formed on the surfaces of the materials of the reinforcement tube and/or the third tube. This corrosion layer may also be formed at any stage prior to the heat treatment. Furthermore, additional deformation processes may be applied between subsequent heat treatments.

It is understood that the order of some of the process steps may be modified. For examples, in an alternative embodiment, the first tube comprising the loose powder or compacted powder is introduced into a reinforcement tube with preformed holes or another form of preformed opening(s). The holes or opening(s) may be filled with a metal or metal-alloy, which is permeable to oxygen at high temperature, in order to avoid closing the holes during the further processing. Additionally or alternatively, the additional third layer of an oxygen permeable third material, preferably a metal or a metal-alloy, which is added to maintain the integrity of the composite during further processing, can be provided prior to the first deformation process 430.

In an alternative process, the loose powder or compacted powder is filled directly into a preformed composite tubular structure comprising at least the first tube and the reinforcement tube described above.

In the following an example of a manufacturing process for producing a superconducting tape is described: Commercial precursor powders with Bi_{2.03}Pb_{0.34}Sr_{1.91}Ca_{2.03}Cu_{3.06}O_{10.δ} nominal composition (Merck) were calcined at 815°C for 60h prior to further handling. After grinding in an agate mortar, the powders were loaded into an Ag tube with 8mm external diameter and 1 mm wall thickness applying hand pressure. The ends of the tube were closed by Ag plugs. Deformation was performed by drawing down to an external diameter of 3.09 mm. This wire was then inserted into a Ni tube (outer diameter: 4.5mm, wall thickness 0.673mm). The composite was further deformed by drawing down to an external diameter of 2.2 mm and then flat-rolled to a thickness of 325 µm and a width of 3.2 mm. Short pieces (3.5 cm) were cut from the tape for the heat treatments. To allow for O₂ exchange between the ceramic core and the surrounding atmosphere, the external Ni sheath was removed on one edge of the samples by polishing. Heat treatments were performed in an atmosphere consisting of 8.5% O₂ (rest N₂). The sintering temperature of 830°C was reached at a rate of 100°C/h. After a 20h dwell at 830°C, the samples were cooled at a rate of 0.5° C per hour down to 770°C and then at a rate of 100°C per hour down to room temperature. A critical current density of 34000 A/cm² was measured by the standard four probe technique in liquid nitrogen. However, in such samples without a third layer, the reinforcement layer (Ni) sometimes deforms locally in an uncontrollable manner such that the critical current density is reduced locally to zero.

In the following, another example of a manufacturing process for producing a superconducting tape is described: commercial precursor powders with Bi_{2.03}Pb_{0.34}Sr_{1.91}Ca_{2.03}Cu_{3.06}O_{10-δ} nominal composition (Merck) were calcined at 815°C for 60h prior to further handling. After grinding in an agate mortar, the powders were loaded into an Ag tube with 5mm external diameter and 0.5mm wall thickness applying hand pressure. The ends of the tube were closed by Cu plugs. This tube was then inserted into a Ni tube (outer diameter: 4.5mm, wall thickness 0.673mm), in which holes with 1 mm diameter had been drilled. This Ni tube and its content were then inserted in an Ag tube with 10mm external diameter and 1 mm wall thickness. The composite was deformed by drawing down to an external diameter of 2.2 mm and then flat-rolled to a thickness of 250 µm and a width of 3.2 mm. Short pieces (3.5 cm) were cut from the tape for heat treatments. The heat treatment was performed in an atmosphere consisting of 8.5.% O₂ (rest N₂). The sintering temperature of 830°C was reached at a rate of 100°C/h. After a 20h dwell at 830°C, the samples were cooled at a rate of 0.5° C per hour down to 770°C and then at a rate of 100°C per hour down to room temperature. No detrimental local deformation took place in the composite sheath and the formation of a high quality superconducting core was assessed by cryogenic measurements.

Fig. 5 shows cross-sectional views of examples of a multi-filament superconducting wire 100 having more than one superconducting cores/filaments.

In the embodiment of fig. 5a, the superconducting wire 100 comprises a plurality of elongated cores 110 of the superconducting material embedded in a matrix 120 of the first material as described herein. Hence, in this embodiment, the first material provides a tubular layer around each of the cores 110. The article 100 further comprises a reinforcement tubular layer 130 of a second material that partially surrounds the composite of the plurality of cores and their surrounding first layer. As described herein, the reinforcement layer 130 includes an opening 140 for allowing oxygen to reach the composite structure of the cores 110 and the first material 120 during a heating process. The article 100 further comprises a third tubular layer 150 surrounding the reinforcement layer 130 and the opening 140 completely. For example, the composite of fig. 5a may be manufactured by providing a plurality of first tubes of a first material 120 each surrounding an elongated core 110 of a superconducting material, e.g. a plurality of Ag tubes, each filled with a powder of a superconducting material. The plurality of first tubes may then be inserted in a reinforcement tube of the second material such that the reinforcement tube surrounds the plurality of first tubes.

In the embodiment of fig. 5b, the superconducting wire 100 comprises a plurality of elongated cores 110 of the superconducting material embedded in a matrix 120 of the first material as described in connection with fig. 5a. However, in the example of fig. 5b, at least one but not all the cores 110 is further partially surrounded by a tubular layer 530 of the second material that includes an opening 540. The article 100 further comprises a reinforcement tubular layer 130 of the second material that partially surrounds the composite of the plurality of cores and their surrounding first layer and reinforcement layers. As described herein, the reinforcement layer 130 includes an opening 140 for allowing oxygen to reach the composite structure including the cores 110. It is understood that the material of the layers 530 and 130 may be the same or comprise different materials. For example, the composite of fig. 5b may be manufactured by providing a plurality of first tubes of a first layer 120 each surrounding an elongated core 110 of a superconducting material, e.g. a plurality of Ag tubes, each filled with a powder of a superconducting material, at least one but not all the tubes further partially surrounded by a reinforcement tube 530 having an opening 540. For example some among the plurality of first tubes may be constructed as the tube of fig. 2a. The plurality of first tubes may then be inserted in a reinforcement tube of the second material such that the reinforcement tube surrounds the plurality of first tubes. Hence this process results in an article in which some of the elongated cores are surrounded by a first tubular layer of a first material, and a reinforcement tubular layer surrounding said first layer, said first layer and reinforcement layers having a structure and composition as described in the case of an article comprising a single core of a superconductive oxide. Hence, generally, all layers of the second material surround the core material only partially along a circumference of the wire/tape so as to allow oxygen to reach the core material.
The article 100 further comprises a third tubular layer 150 surrounding the reinforcement layer 130 and the opening 140 completely.

It is understood that the multi-filament wires of figs. 5a and 5b may be deformed, e.g. rolled or drawn to manufacture a superconducting tape as described herein. In this example, the deformation process thus results in a multifilament superconducting tape.

Although some embodiments have been described and shown in detail, the invention is not restricted to them, but may also be embodied in other ways within the scope of the subject matter defined in the following claims.

Even though the invention has mainly been described in connection with a superconducting material, it will be appreciated that the invention may also be applied to other composite articles in which a ceramic material is embedded and sintered in a metal matrix or sheath. Examples of ceramic materials include alumina, beryllia, a steatite, a stearate, and/or the like whose final characteristics are produced by subjection to high temperatures. Such articles may e.g. be used as microelectronic components or the like. Furthermore, the invention has mainly been described with reference to a superconducting wire or tape. It will be appreciated, however, that the invention may also be applied to articles of different shapes, e.g. to plates or similar plate-shaped articles.

It should be emphasized that the term "comprises/comprising" when used in this specification is taken to specify the presence of stated features, integers, steps or components but does not preclude the presence or addition of one or more other features, integers, steps, components or groups thereof.

## Claims

1. A superconducting article comprising:
- at least one core including a core material, the core material including a superconductive material (110) or one or more materials that are convertible into a superconductive material;
- at least one first matrix (120) of a first material surrounding said at least one core;
- at least one reinforcement matrix (130) of a second material partially surrounding said first material; wherein said reinforcement matrix comprises at least one opening (140) in a circumference of said reinforcement matrix, said opening allowing oxygen to reach the first matrix during at least one step of a manufacturing process of the superconducting article;
- at least one third matrix (150) of a third material surrounding said second material.

2. A superconducting article according to claim 1, wherein the superconducting material includes oxygen as one of its constituents.

3. A superconducting article according to any one of claims 1-2, wherein said first material and said third material are materials permeable to oxygen at least under predetermined conditions.

4. A superconducting article according to any one of claims 1 - 3, wherein at least one of said first material and said third material comprises a metal.

5. A superconducting article according to any one of claims 1-4, wherein said second material is chemically reactive with said core material

6. A superconducting article according to any one of claims 1 through 5, wherein said second material is chemically reactive with said core material when said superconducting article is heated to a temperature in the region between 20°C-1300°C, such as between 300°C - 960°C, such as between 400°C-700°C, such as between 700°C-900°C.

7. A superconducting article according to any one of claims 1-6, wherein said at least one opening in said circumference of said reinforcement matrix is permeable to oxygen.

8. A superconducting article according to any one of claims 1-7, wherein said at least one opening in said circumference of said reinforcement matrix comprises a plurality of preformed holes.

9. A superconducting article according to any one of claims 1-8, wherein said at least one opening is filled with a material permeable to oxygen.

10. A superconducting article according to any of claims 1-9, wherein the superconducting article comprises a corrosion layer on the surface of said reinforcement matrix and/or said third matrix.

11. A superconducting article according to any of claims 1-10, wherein said superconducting material comprises at least one of a superconducting oxide, an oxycarbonate, an oxyfluoride, and an oxychloride.

12. A superconducting article according to any of claims 1 - 11, wherein the article comprises a plurality of cores, each surrounded by a respective first matrix of the first material; and wherein the reinforcement matrix partially surrounds at least one of the plurality of first matrices.

13. A superconducting article according to any one of claims 1-12, wherein said third material is different from said second material.

14. A superconducting article according to any one of claims 1-13, wherein said reinforcement matrix has a radial thickness larger than a radial thickness of the first matrix.

15. A superconducting article according to any one of claims 1-14, wherein said reinforcement matrix has a radial thickness larger than a radial thickness of the third matrix.

16. A method of manufacturing a superconducting article, the method comprising:
- providing at least one core including a core material, the core material comprising a superconductive material or one or more materials convertible into a superconductive material;
- surrounding the at least one core by at least one first matrix comprising a first material;
- partially surrounding the at least one first matrix by at least one reinforcement matrix of a second material;
- surrounding the at least one reinforcement matrix by at least one third matrix of a third material;
- processing the core material surrounded by the first matrix, the reinforcement matrix and the third matrix so as to obtain a sintered superconducting material; wherein said reinforcement matrix comprises at least one opening in a circumference of said reinforcement matrix, said opening allowing oxygen to reach the first matrix during a processing step.

17. A method according to claim 16; further comprising mechanically deforming the superconducting article.

18. A method according to claim 16 or 17, wherein the superconducting article is an article as defined in any one of claims 1 through 15.

19. A method according to any one of claims 16 through 18, wherein processing includes heating the core material surrounded by the first matrix, the reinforcement matrix and the third matrix.

20. A method according to any one of claims 16 through 19, wherein partially surrounding the at least one first matrix by a reinforcement matrix of a second material includes inserting the at least one first matrix into a tube of the second material; and selectively removing a part of a wall of the tube.

21. A method according to any one of claims 16 through 20, comprising partially surrounding the at least one first matrix by the reinforcement matrix of a second material; and surrounding the core material by the at least one first matrix partially surrounded by the reinforcement matrix of a second material.

22. A composite article comprising:
- at least one core including a core material, the core material including a ceramic material or one or more materials that are convertible into a ceramic;
- at least one first matrix of a first material surrounding said at least one core;
- at least one reinforcement matrix of a second material partially surrounding said at least one first material; wherein said reinforcement matrix comprises at least one opening in a circumference of said reinforcement matrix, said opening allowing oxygen to reach the first matrix during a sintering process of the composite article;
- at least one third matrix of a third material surrounding said at least one second material.

23. A method of manufacturing a composite article, the method comprising:
- providing at least one core including a core material, the core material comprising a ceramic material or one or more materials convertible into a ceramic material;
- surrounding the at least one core by at least one first matrix comprising a first material;
- partially surrounding the at least one first matrix by at least one reinforcement matrix of a second material;
- surrounding the at least one reinforcement matrix by at least one third matrix of a third material;
- processing the core material surrounded by the first matrix, the reinforcement matrix, and the third matrix so as to obtain a sintered ceramic material; wherein said reinforcement matrix comprises at least one opening in a circumference of said reinforcement matrix, said opening allowing oxygen to reach the first matrix during a heating step.

## Patentansprüche

1. Supraleitender Artikel, umfassend:
- zumindest einen ein Kernmaterial enthaltenden Kern, welches Kernmaterial ein supraleitendes Material (110) oder ein oder mehrere in ein supraleitendes Material umwandelbare Materialien enthält;
- zumindest eine den mindestens einen Kern umschließende erste Matrix (120) eines ersten Materials;
- zumindest eine das erste Material teilweise umschließende Verstärkungsmatrix (130) eines zweiten Materials; wobei die Verstärkungsmatrix zumindest eine Öffnung (140) in einem Umfang der Verstärkungsmatrix umfasst, welche Öffnung dem Sauerstoff ermöglicht, während mindestens eines Schritts eines Herstellungsverfahrens des supraleitenden Artikels zur ersten Matrix zu gelangen;
- zumindest eine das zweite Material umschließende dritte Matrix (150) eines dritten Materials.

2. Supraleitender Artikel nach Anspruch 1, wobei das supraleitende Material Sauerstoff als einen seiner Bestandteile enthält.

3. Supraleitender Artikel nach irgendeinem der Ansprüche 1-2, wobei das erste Material und das dritte Material zumindest unter vorbestimmten Bedingungen sauerstoffdurchlässige Materialien sind.

4. Supraleitender Artikel nach irgendeinem der Ansprüche 1-3, wobei mindestens eines des ersten Materials und des dritten Materials ein Metall umfasst.

5. Supraleitender Artikel nach irgendeinem der Ansprüche 1-4, wobei das zweite Material mit dem Kernmaterial chemisch reaktiv ist.

6. Supraleitender Artikel nach irgendeinem der Ansprüche 1-5, wobei das zweite Material mit dem Kernmaterial chemisch reaktiv ist, wenn der supraleitende Artikel auf eine Temperatur im Bereich zwischen 20°C-1300°C, wie etwa zwischen 300°C-960°C, wie etwa zwischen 400°C-700°C, wie etwa zwischen 700°C-900°C erwärmt wird.

7. Supraleitender Artikel nach irgendeinem der Ansprüche 1-6, wobei die mindestens eine Öffnung in dem Umfang der Verstärkungsmatrix für Sauerstoff durchlässig ist.

8. Supraleitender Artikel nach irgendeinem der Ansprüche 1-7, wobei die mindestens eine Öffnung in dem Umfang der Verstärkungsmatrix eine Vielzahl von vorgeformten Löchern umfasst.

9. Supraleitender Artikel nach irgendeinem der Ansprüche 1-8, wobei die mindestens eine Öffnung mit einem sauerstoffdurchlässigen Material gefüllt ist.

10. Supraleitender Artikel nach irgendeinem der Ansprüche 1-9, wobei der supraleitende Artikel eine Korrosionsschicht auf der Oberfläche der Verstärkungsmatrix und/oder der dritten Matrix umfasst.

11. Supraleitender Artikel nach irgendeinem der Ansprüche 1-10, wobei das supraleitende Material zumindest eines von einem supraleitenden Oxid, einem Oxycarbonat, einem Oxyfluorid und einem Oxychlorid umfasst.

12. Supraleitender Artikel nach irgendeinem der Ansprüche 1-11, wobei der Artikel eine Vielzahl von Kernen umfasst, wobei jeder von einer jeweiligen ersten Matrix des ersten Materials umschlossen ist; und wobei die Verstärkungsmatrix zumindest eine der Vielzahl von ersten Matrizen teilweise umschließt.

13. Supraleitender Artikel nach irgendeinem der Ansprüche 1-12, wobei das dritte Material vom zweiten Material verschieden ist.

14. Supraleitender Artikel nach irgendeinem der Ansprüche 1-13, wobei die Verstärkungsmatrix eine als eine radiale Dicke der ersten Matrix größere radiale Dicke aufweist.

15. Supraleitender Artikel nach irgendeinem der Ansprüche 1-14, wobei die Verstärkungsmatrix eine als eine radiale Dicke der dritten Matrix größere radiale Dicke aufweist.

16. Verfahren zur Herstellung eines supraleitenden Artikels, welches Verfahren:
- eine Bereitstellung zumindest eines ein Kernmaterial enthaltenden Kerns, welches Kernmaterial ein supraleitendes Material oder ein oder mehrere in ein supraleitendes Material umwandelbare Materialien umfasst;
- eine Umschließung des mindestens einen Kerns durch zumindest eine erste Matrix, umfassend ein erstes Material;
- eine teilweise Umschließung der mindestens einen ersten Matrix durch zumindest eine Verstärkungsmatrix eines zweiten Materials;
- eine Umschließung der mindestens einen Verstärkungsmatrix durch zumindest eine dritte Matrix eines dritten Materials;
- eine Verarbeitung des von der ersten Matrix, der Verstärkungsmatrix und der dritten Matrix umschlossenen Kernmaterials zur Erhaltung eines gesinterten supraleitenden Materials; wobei die Verstärkungsmatrix zumindest eine Öffnung in einem Umfang der Verstärkungsmatrix umfasst, welche Öffnung dem Sauerstoff ermöglicht, zur ersten Matrix während eines Verarbeitungsschritts zu gelangen,
umfasst.

17. Verfahren nach Anspruch 16; welches Verfahren zusätzlich eine mechanische Verformung des supraleitenden Artikels umfasst.

18. Verfahren nach Anspruch 16 oder 17, wobei der supraleitende Artikel ein Artikel, wie in irgendeinem der Ansprüche 1 bis 15 definiert, ist.

19. Verfahren nach irgendeinem der Ansprüche 16 bis 18, wobei die Verarbeitung eine Erwärmung des von der ersten Matrix, der Verstärkungsmatrix und der dritten Matrix umschlossenen Kernmaterials beinhaltet.

20. Verfahren nach irgendeinem der Ansprüche 16 bis 19, wobei die teilweise Umschließung der mindestens einen ersten Matrix durch eine Verstärkungsmatrix eines zweiten Materials das Einsetzen der mindestens einen ersten Matrix in ein Rohr des zweiten Materials; und die selektive Entfernung eines Teils einer Wand des Rohrs beinhaltet.

21. Verfahren nach irgendeinem der Ansprüche 16 bis 20, umfassend eine teilweise Umschließung der mindestens einen ersten Matrix durch die Verstärkungsmatrix eines zweiten Materials; und eine Umschließung des Kernmaterials durch die mindestens eine von der Verstärkungsmatrix eines zweiten Materials teilweise umschlossene erste Matrix.

22. Zusammengesetzter Artikel, umfassend:
- zumindest einen ein Kernmaterial enthaltenden Kern, welches Kernmaterial ein keramisches Material oder ein oder mehrere in eine Keramik umwandelbare Materialien enthält;
- zumindest eine den mindestens einen Kern umschließende erste Matrix eines ersten Materials;
- zumindest eine das mindestens eine erste Material teilweise umschließende Verstärkungsmatrix eines zweiten Materials; wobei die Verstärkungsmatrix zumindest eine Öffnung in einem Umfang der Verstärkungsmatrix umfasst, welche Öffnung dem Sauerstoff ermöglicht, während eines Sinterverfahrens des zusammengesetzten Artikels zur ersten Matrix zu gelangen;
- zumindest eine das mindestens eine zweite Material umschließende dritte Matrix eines dritten Materials.

23. Verfahren zur Herstellung eines zusammengesetzten Artikels, welches Verfahren:
- eine Bereitstellung zumindest eines ein Kernmaterial enthaltenden Kerns, welches Kernmaterial ein keramisches Material oder ein oder mehrere in ein keramisches Material umwandelbare Materialien umfasst;
- eine Umschließung des mindestens einen Kerns durch zumindest eine erste Matrix, umfassend ein erstes Material;
- eine teilweise Umschließung der mindestens einen ersten Matrix durch zumindest eine Verstärkungsmatrix eines zweiten Materials;
- eine Umschließung der mindestens einen Verstärkungsmatrix durch zumindest eine dritte Matrix eines dritten Materials;
- eine Verarbeitung des von der ersten Matrix, der Verstärkungsmatrix und der dritten Matrix umschlossenen Kernmaterials zur Erhaltung eines gesinterten keramischen Materials; wobei die Verstärkungsmatrix zumindest eine Öffnung in einem Umfang der Verstärkungsmatrix umfasst, welche Öffnung dem Sauerstoff ermöglicht, zur ersten Matrix während eines Erwärmungsschritts zu gelangen,
umfasst.

## Revendications

1. Article supraconducteur, comprenant:
- au moins un noyau comprenant un matériau d'âme, le matériau d'âme comprenant un matériau supraconducteur (110) ou un ou plusieurs matériaux qui sont convertibles en un matériau supraconducteur;
- au moins une première matrice (120) d'un premier matériau entourant ledit au moins un noyau;
- au moins une matrice de renfort (130) d'un deuxième matériau entourant partiellement ledit premier matériau, dans lequel ladite matrice de renfort comporte au moins une ouverture (140) dans une circonférence de ladite matrice de renfort, ladite ouverture permettant à l'oxygène d'atteindre la première matrice pendant au moins une étape d'un processus de fabrication de l'article supraconducteur;
- au moins une troisième matrice (150) d'un troisième matériau entourant ledit deuxième matériau.

2. Article supraconducteur selon la revendication 1, dans lequel le matériau supraconducteur comprend l'oxygène comme l'un de ses constituants.

3. Article supraconducteur selon l'une quelconque des revendications 1 à 2, dans lequel ledit premier matériau et ledit troisième matériau sont des matériaux perméables à l'oxygène au moins dans des conditions prédéterminées.

4. Article supraconducteur selon l'une quelconque des revendications 1 à 3, dans lequel au moins l'un dudit premier matériau et dudit troisième matériau comprend un métal.

5. Article supraconducteur selon l'une quelconque des revendications 1 à 4, dans lequel ledit deuxième matériau est chimiquement réactif avec ledit matériau d'âme.

6. Article supraconducteur selon l'une quelconque des revendications 1 à 5, **caractérisé en ce que** ledit deuxième matériau est chimiquement réactif avec ledit matériau d'âme lorsque ledit article supraconducteur est chauffé à une température dans la région comprise entre 20°C-1300°C, comme par exemple entre 300°C - 960°C, comme par exemple entre 400°C-700°C, comme par exemple entre 700°C-900°C.

7. Article supraconducteur selon l'une quelconque des revendications 1 à 6, dans lequel ladite au moins une ouverture dans ladite circonférence de ladite matrice de renforcement est perméable à l'oxygène.

8. Article supraconducteur selon l'une quelconque des revendications 1 à 7, dans lequel ladite au moins une ouverture dans ladite circonférence de ladite matrice de renfort comporte une pluralité de trous préformés.

9. Article supraconducteur selon l'une quelconque des revendications 1 à 8, dans lequel ladite au moins une ouverture est remplie d'un matériau perméable à l'oxygène.

10. Article supraconducteur selon l'une quelconque des revendications 1 à 9, dans lequel l'article supraconducteur comprend une couche de corrosion sur la surface de ladite matrice de renfort et/ou ladite troisième matrice.

11. Article supraconducteur selon l'une quelconque des revendications 1 à 10, dans lequel ledit matériau supraconducteur comprend au moins l'un d'un oxyde supraconducteur, d'un oxycarbonate, d'un oxyfluorure et d'un oxychlorure.

12. Article supraconducteur selon l'une des revendications 1 à 11, dans lequel l'article comporte une pluralité de noyaux, dont chacun est entouré par une respective première matrice du premier matériau; et dans lequel la matrice de renforcement entoure partiellement au moins l'une de la pluralité des premières matrices.

13. Article supraconducteur selon l'une quelconque des revendications 1 à 12, dans lequel ledit troisième matériau est différent dudit deuxième matériau.

14. Article supraconducteur selon l'une quelconque des revendications 1 à 13, dans lequel ladite matrice de renfort présente une épaisseur radiale supérieure à l'épaisseur radiale de la première matrice.

15. Article supraconducteur selon l'une quelconque des revendications 1 à 14, dans lequel ladite matrice de renfort présente une épaisseur radiale supérieure à l'épaisseur radiale de la troisième matrice.

16. Procédé de fabrication d'un article supraconducteur, le procédé comprenant:
- fournir au moins un noyau comprenant un matériau d'âme, le matériau d'âme comprenant un matériau supraconducteur ou un ou plusieurs matériaux convertibles en un matériau supraconducteur;
- entourer l'au moins un noyau par au moins une première matrice comprenant un premier matériau;
- entourer partiellement l'au moins une première matrice par au moins une matrice de renfort d'un deuxième matériau;
- entourer l'au moins une matrice de renfort par au moins une troisième matrice d'un troisième matériau,
- traiter le matériau d'âme entouré par la première matrice, la matrice de renfort et la troisième matrice afin d'obtenir un matériau fritté supraconducteur; dans lequel ladite matrice de renfort comporte au moins une ouverture dans une circonférence de ladite matrice de renfort, ladite ouverture permettant à l'oxygène d'atteindre la première matrice lors d'une étape de traitement.

17. Procédé selon la revendication 16; comprenant en outre une déformation mécanique de l'article supraconducteur.

18. Procédé selon la revendication 16 ou 17, dans lequel l'article supraconducteur est un article tel que défini dans l'une des revendications 1 à 15.

19. Procédé selon l'une quelconque des revendications 16 à 18, où le traitement comprend le chauffage du matériau d'âme entouré par la première matrice, la matrice de renfort et la troisième matrice.

20. Procédé selon l'une quelconque des revendications 16 à 19, dans lequel entourant partiellement l'au moins une première matrice par une matrice de renfort d'un deuxième matériau comprend l'insertion de l'au moins une première matrice dans un tube du deuxième matériau; et l'élimination sélective d'une partie d'une paroi du tube.

21. Procédé selon l'une quelconque des revendications 16 à 20, comprenant entourant partiellement l'au moins une première matrice par la matrice de renfort d'un deuxième matériau; et entourant le matériau d'âme par l'au moins une matrice partiellement entourée par la matrice de renforcement d'un deuxième matériau.

22. Article composite comprenant:
- au moins un noyau comprenant un matériau d'âme, le matériau d'âme comprenant un matériau céramique ou une ou plusieurs matériaux qui sont convertibles en une céramique;
- au moins une première matrice d'un premier matériau entourant ledit au moins un noyau;
- au moins une matrice de renfort d'un deuxième matériau entourant partiellement ledit au moins un premier matériau; où ladite matrice de renfort comporte au moins une ouverture dans une circonférence de ladite matrice de renfort, ladite ouverture permettant à l'oxygène d'atteindre la première matrice pendant un procédé de frittage de l'article composite,
- au moins une troisième matrice d'un troisième matériau entourant ledit au moins un second matériau.

23. Procédé de fabrication d'un article composite, le procédé comprenant:
- fournir au moins un noyau comprenant un matériau d'âme, le matériau d'âme comprenant un matériau céramique ou un ou plusieurs matériaux convertibles en un matériau céramique;
- entourer l'au moins un noyau par au moins une première matrice comprenant un premier matériau;
- entourer partiellement l'au moins une première matrice par au moins une matrice de renfort d'un deuxième matériau;
- entourer l'au moins une matrice de renfort par au moins une troisième matrice d'un troisième matériau,
- traiter le matériau d'âme entouré par la première matrice, la matrice de renfort et la troisième matrice afin d'obtenir un matériau céramique fritté; où ladite matrice de renfort comporte au moins une ouverture dans une circonférence de ladite matrice de renfort, ladite ouverture permettant à l'oxygène d'atteindre la première matrice lors d'une étape de chauffage.
